# FASCICULE DE BREVET EUROPEEN

(11) **EP 4 070 455 B1**
(45) Date de publication et mention de la délivrance du brevet: **12.06.2024**
(21) Numéro de dépôt: 20816262.8
(22) Date de dépôt: 04.12.2020
(51) Int. Cl.: H03K 17/082, B60L 3/00

(54) **DISPOSITIF ET PROCÉDÉ DE DÉCHARGE ACTIVE**
AKTIVE ENTLADEVORRICHTUNG UND -VERFAHREN
ACTIVE DISCHARGE DEVICE AND METHOD

(30) Priorité: 06.12.2019 FR 1913894
(43) Date de publication de la demande: 12.10.2022
(73) Titulaire: Valeo eAutomotive France SAS, 95800 Cergy (FR)
(72) Inventeur: BAKHALI, Yamna, 95800 Cergy (FR)
(74) Mandataire: Valeo Powertrain Systems
(86) Numéro de dépôt international: PCT/EP2020/084751
(87) Numéro de publication internationale: WO 2021/110980

(56) Documents cités:
- EP-A2- 2 639 916

## Description

La présente invention concerne un dispositif et un procédé de décharge active.

L'invention s'applique particulièrement dans le domaine des véhicules automobiles, en particulier ceux à propulsion électrique ou bien hybride.

En effet, de tels véhicules automobiles comportent des organes électriques comportant en entrée et/ou en sortie des dispositifs de stockage d'énergie électrique, tels que des capacités. La tension aux bornes de ces dispositifs de stockage peut être élevée, par exemple comprise entre 60 V et 1 000 V. Lorsque l'entrée ou bien la sortie de l'organe électrique est déconnectée, l'énergie électrique reste stockée dans le dispositif de stockage. Ainsi, si une personne entre en contact avec le dispositif de stockage, par exemple lors d'une opération de maintenance du véhicule automobile, l'énergie stockée peut se décharger à travers cette personne et la blesser.

Pour éviter cela, il est connu d'utiliser un dispositif de décharge active conçu pour décharger sur commande le dispositif de stockage d'énergie électrique. Comme beaucoup d'énergie électrique doit être déchargée en peu de temps, la puissance dissipée par le dispositif de décharge active est importante, ce qui peut entraîner un échauffement de ses composants pouvant aller jusqu'à un départ de feu. Il est donc généralement prévu une protection contre l'échauffement.

Par exemple, les demandes de brevet publiées sous les numéros US 2011/0057627 A1 et EP 2 639 916 A2 décrivent un dispositif de décharge active d'un dispositif de stockage d'énergie électrique, du type comportant :
- une branche comportant :
   - des première et deuxième extrémités destinées à être respectivement connectées à des bornes positive et négative du dispositif de stockage d'énergie électrique, et
   - entre les deux extrémités, une thermistance présentant une résistance augmentant avec une température de la thermistance et un interrupteur conçu pour recevoir un signal de commande pour passer d'un état ouvert à un état fermé, la thermistance et l'interrupteur étant connectés l'un à l'autre de sorte que, lorsque l'interrupteur est à l'état fermé, un courant de décharge entre par la première extrémité, traverse la thermistance et l'interrupteur l'un après l'autre et sorte par la deuxième extrémité ; et
- un dispositif de commande de l'interrupteur.

Dans cette demande de brevet, l'interrupteur est un transistor à effet de champ à grille métal-oxyde (de l'anglais « Metal Oxide Semiconductor Field Effect Transistor » ou bien MOSFET) présentant : un drain d'entrée de courant, une source de sortie de courant et une grille. Pour cet interrupteur, le signal de commande est la tension grille-source. Plus précisément, l'interrupteur est ouvert lorsque la tension grille-source est nulle et fermé lorsqu'elle est non-nulle. Dans ce dernier cas, le courant de décharge puisé par l'interrupteur augmente avec la tension grille-source. En outre, la thermistance est connectée à la source de l'interrupteur et le dispositif de commande est agencé pour fournir une tension de fermeture de l'interrupteur entre la thermistance et la grille de l'interrupteur. Du fait de la présence d'une diode Zener en sortie du dispositif de commande, la tension de fermeture est sensiblement constante. Ainsi, la tension grille-source est égale à la différence entre la tension de fermeture (constante) et la tension aux bornes de la thermistance.

En cas d'échauffement de l'interrupteur, la température de la thermistance augmente du fait d'un couplage thermique entre l'interrupteur et la thermistance, ce qui entraîne une augmentation de la résistance de la thermistance et donc de la tension à ses bornes. Il en résulte une baisse de la tension grille-source et donc une baisse du courant de décharge traversant l'interrupteur, ce qui limite son échauffement.

Un problème du dispositif de décharge active proposé dans la demande de brevet précédente, est que l'essentiel de la puissance de décharge est obligatoirement dissipée dans l'interrupteur, ce qui peut réduire sa durée de vie ou bien l'endommager.

Il peut ainsi être souhaité de prévoir un dispositif de décharge active qui permette de réduire la puissance dissipée par l'interrupteur.

Il est donc proposé un dispositif de décharge active d'un dispositif de stockage d'énergie électrique, du type précité, caractérisé en ce que le dispositif de commande est connecté à l'interrupteur de manière à fournir le signal de commande indépendamment de la résistance de la thermistance.

En effet, dans la demande de brevet ci-dessus, comme la tension grille-source dépend de la résistance de la thermistance, la thermistance doit obligatoirement présenter une résistance faible, afin que la tension à ses bornes ne soit pas trop élevée et ne vienne pas annuler la tension grille-source au moindre courant de décharge.

Grâce à l'invention, le dispositif de commande fournit le signal de commande indépendamment de la résistance de la thermistance. Ainsi, la thermistance peut être choisie avec une résistance très élevée, de sorte qu'elle peut dissiper l'essentiel de la puissance de décharge. L'interrupteur n'a alors besoin de dissiper qu'une petite partie de la puissance de décharge et présente peu de risque d'échauffement et d'usure au cours du temps.

De façon optionnelle, le dispositif de décharge active comporte en outre au moins une connexion de fourniture du signal de commande, connectant le dispositif de commande à l'interrupteur, et dans lequel la thermistance est située en dehors de chaque connexion de fourniture du signal de commande. Autrement dit, la connexion de fourniture du signal de commande entre le dispositif de commande et l'interrupteur est dépourvue de ladite thermistance.

De façon optionnelle également, l'interrupteur présente une borne d'entrée du courant de décharge, une borne de sortie du courant de décharge et une borne de commande, le signal de commande est une tension de commande entre la borne de commande et la borne de sortie, et le dispositif de décharge active comporte deux connexions de fourniture du signal de commande connectant le dispositif de commande respectivement à la borne de commande et à la borne de sortie.

De façon optionnelle également, la thermistance est connectée entre la première extrémité de la branche et la borne d'entrée de l'interrupteur.

De façon optionnelle également, la thermistance est connectée entre la borne de sortie de l'interrupteur et la deuxième extrémité de la branche.

De façon optionnelle également, la connexion de fourniture du signal de commande connectant le dispositif de commande à la borne de sortie comporte une connexion entre le dispositif de commande et un point de la branche situé entre la borne de sortie de l'interrupteur et la thermistance.

De façon optionnelle également, la thermistance est thermiquement découplée de l'interrupteur, par exemple au moyen d'une barrière d'isolation thermique intercalée entre eux.

De façon optionnelle également, la thermistance est située à une distance de l'interrupteur d'au moins 1 cm.

De façon optionnelle également, la résistance de la thermistance à 25°C est au moins 10 fois supérieure à une résistance de l'interrupteur à l'état fermé, de préférence 100 fois supérieure, de préférence encore 1 000 fois supérieure.

De façon optionnelle également, la thermistance est conçue pour réaliser l'une plusieurs des fonctions suivantes, de préférence les deux :
- dissiper plus de puissance que l'interrupteur ; et
- limiter le courant de décharge lorsque la température de la thermistance augmente.

Il est également proposé un procédé de décharge active d'un dispositif de stockage comme revendiqué dans la revendication 11.

L'invention sera mieux comprise à l'aide de la description qui va suivre, donnée uniquement à titre d'exemple et faite en se référant aux dessins annexés dans lesquels :
[Fig. 1] la figure 1 représente schématiquement un véhicule automobile à propulsion électrique ou bien hybride avec des organes électriques, dont certains comportent au moins un dispositif de stockage d'énergie,
[Fig. 2] la figure 2 est un schéma électrique d'un dispositif de décharge active, selon un premier mode de réalisation de l'invention, d'un des dispositifs de stockage d'énergie de la figure 1,
[Fig. 3] la figure 3 est un graphique représentant des caractéristiques courant - tension d'un interrupteur du dispositif de décharge active de la figure 2,
[Fig. 4] la figure 4 illustre les étapes successives d'un procédé de décharge active, selon un mode de réalisation de l'invention, et
[Fig. 5] la figure 5 est un schéma électrique d'un dispositif de décharge active, selon un deuxième mode de réalisation de l'invention, d'un des dispositifs de stockage d'énergie de la figure 1.

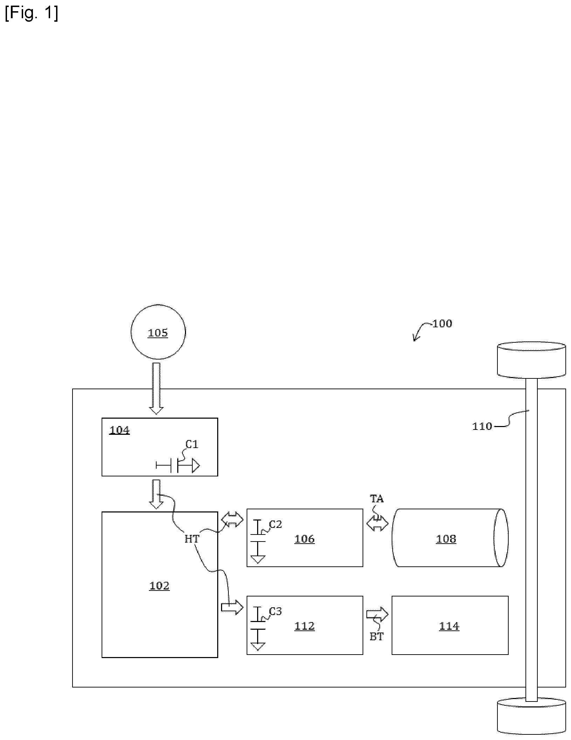

En référence à la figure 1, un véhicule automobile 100 à propulsion électrique ou bien hybride (avec un moteur électrique et un moteur thermique) comporte différents organes électriques.

En particulier, le véhicule automobile 100 comporte tout d'abord une batterie haute tension 102 conçue pour fournir une haute tension HT continue supérieure à 60 V, généralement comprise entre 60 V et 1 000 V.

Le véhicule automobile 100 comporte en outre un chargeur 104 conçu pour charger la batterie haute tension 102 à partir d'un réseau électrique 105.

Le véhicule automobile 100 comporte en outre un onduleur/redresseur 106 conçu pour sélectivement soit fournir au moins une tension alternative TA à partir la haute tension HT, soit recharger la batterie haute tension 102 à partir de la ou des tensions alternatives TA.

Le véhicule automobile 100 comporte en outre un moteur électrique 108 d'entraînement de roues motrices 110 du véhicule automobile 100. Le moteur électrique 108 est alimenté par la ou les tensions alternatives TA. Généralement, le moteur électrique 108 peut en outre fonctionner en mode générateur, dans lequel l'entraînement des roues 110 génère la ou les tensions alternatives TA pour que l'onduleur/redresseur 106 recharge la batterie haute tension 102.

Le véhicule automobile 100 comporte en outre un convertisseur continu-continu 112 conçu pour fournir une basse tension BT continue à partir de la haute tension HT.

Le véhicule automobile 100 comporte en outre une batterie basse tension 114 conçue pour fournir la basse tension BT à différents systèmes électriques (non représentés) du véhicule automobile 100 pour les alimenter. La batterie basse tension 114 peut en outre être rechargée par la batterie haute tension 102 au travers du convertisseur continu-continu 112.

Le chargeur 104, l'onduleur/redresseur 106 et le convertisseur continu-continu 112 présente chacun une capacité, respectivement C1, C2 et C3, à laquelle la haute tension HT est appliquée et emmagasinant de ce fait beaucoup d'énergie électrique.

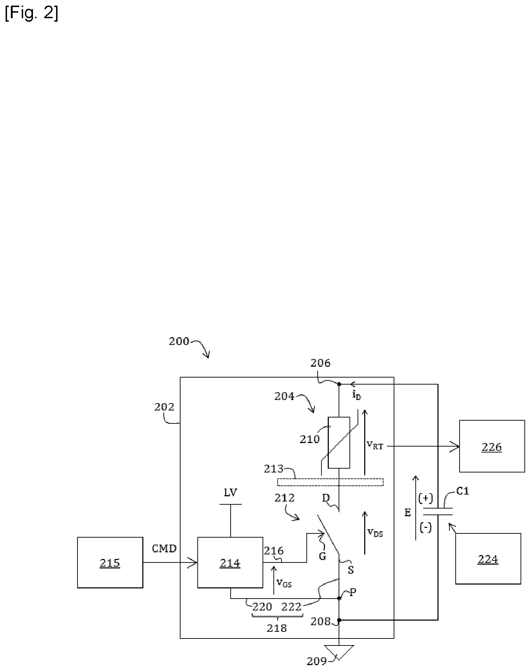

En référence à a figure 2, un dispositif de décharge active 200 selon un premier mode de réalisation de l'invention et présent dans le véhicule automobile 100 va à présent être décrit.

Le dispositif de décharge active 200 est conçu pour décharger à la demande un dispositif de stockage d'énergie électrique du véhicule automobile 100. Par exemple, chacune des capacités C1 à C3 et des batteries 102, 114 peut être associée à un dispositif de décharge active comme le dispositif de décharge active 200. Dans la description qui va suivre, le cas de la décharge active de la capacité C1 sera pris comme exemple non limitatif.

Le dispositif de décharge active 200 comporte tout d'abord une carte de circuit imprimé 202 (de l'anglais « Printed Circuit Board » ou PCB).

Le dispositif de décharge active 200 comporte en outre, sur la carte de circuit imprimé 202, une branche 204 de décharge de courant comportant tout d'abord une première extrémité 206 connectée à une borne positive (+) de la capacité C1 pour recevoir un courant de décharge i_{D} et une deuxième extrémité 208 connectée à une borne négative (-) de la capacité C1, par exemple au travers d'une masse électrique 209 à laquelle la borne négative (-) est connectée.

La branche 204 comporte en outre, entre les deux extrémités 206, 208, une thermistance 210 destinée, dans l'exemple décrit, à remplir trois fonctions : une première fonction de dissipation de puissance, une deuxième fonction de protection thermique de la décharge et une troisième fonction de vérification du bon fonctionnement de la décharge. Ces trois fonctions seront apparentes à la lecture du reste de la description. La branche 204 comporte en outre, toujours entre les deux extrémités 206, 208, un interrupteur 212. La thermistance 210 et l'interrupteur 212 sont connectés l'un à l'autre de sorte que le courant de décharge i_{D} les traverse l'un après l'autre. Dans l'exemple décrit, la thermistance 210 est connectée à la première extrémité 206, tandis que l'interrupteur 212 est connecté à la deuxième extrémité 208. Ainsi, le courant de décharge i_{D} traverse d'abord la thermistance 210, puis l'interrupteur 212.

La thermistance 210 est une thermistance à coefficient de température positif (de l'anglais « Positive Température Coefficient » ou bien PTC), c'est-à-dire qu'elle présente une résistance RT augmentant avec une température de la thermistance 210. De préférence, le dispositif de décharge active 200 utilise une thermistance ayant une résistance RT très élevée, par exemple comprise entre 1 kΩ et 100 kΩ à 25 °C.

L'interrupteur 212 est conçu pour recevoir un signal de commande définissant son état, ouvert ou bien fermé. Dans l'état ouvert, l'interrupteur 212 coupe la branche 204 de sorte que le courant de décharge i_{D} est nul. Dans l'état fermé, l'interrupteur 212 draine le courant de décharge i_{D}. Dans ce dernier cas, il présente alors une résistance r faible, généralement comprise entre 1 mΩ et 100 mΩ. Ainsi, la résistance RT à 25 °C est au moins 10 fois supérieure à la résistance r, et de préférence 100 fois supérieure, voire 1 000 supérieure. De cette manière, lors de la décharge, l'essentiel de la puissance est dissipée dans la thermistance 210. Plus précisément, la thermistance 210 dissipe la puissance RT × i_{D}², tandis que l'interrupteur 212 dissipe la puissance r × i_{D}². Ainsi, lorsque la résistance RT est 100 fois supérieure à la résistance r, la thermistance 210 dissipe 100 fois plus d'énergie que l'interrupteur 212. Ainsi, l'interrupteur 212 s'échauffe très peu et présente un risque très réduit de provoquer un départ de feu.

La thermistance 210 et l'interrupteur 212 sont de préférence découplés thermiquement l'un de l'autre afin que la thermistance 210 ne vienne pas chauffer l'interrupteur 212. Cela peut être obtenu en les éloignant l'un de l'autre d'une distance d'au moins 1 cm et/ou en utilisant une barrière d'isolation thermique 213.

L'interrupteur 212 présente des bornes d'entrée D et de sortie S du courant de décharge i_{D}, ainsi qu'une borne de commande G. Dans l'exemple décrit, le signal de commande est une tension de commande v_{GS} entre la borne de commande G et la borne de sortie S. En outre, la résistance r est la résistance entre les bornes d'entrée D et de sortie S.

Dans l'exemple décrit, l'interrupteur 212 est un transistor à effet de champ à grille métal-oxyde (de l'anglais « Metal Oxide Semiconductor Field Effect Transistor » ou bien MOSFET) présentant, comme cela est connu en soi, un drain, une source et une grille formant respectivement la borne d'entrée D, la borne de sortie S et la borne de commande G.

L'interrupteur 212 peut aussi être un transistor bipolaire, un transistor bipolaire à grille isolée (de l'anglais « Insulated Gate Bipolar Transistor » ou IGBT), un thyristor ou tout autre interrupteur commandable.

Le dispositif de décharge active 200 comporte en outre un dispositif 214 de commande de l'interrupteur 212 connecté à l'interrupteur 212 de manière à lui fournir le signal de commande v_{GS} indépendamment de la résistance RT de la thermistance 210, en réponse à la réception d'une commande de décharge CMD provenant par exemple d'un calculateur 215 du véhicule automobile 100. Le dispositif de commande 214 est de préférence alimenté par la basse tension LV de la batterie basse tension 114. Le dispositif de commande 214 peut aussi être alimenté indirectement par la haute tension HT de la batterie haute tension 102.

Dans l'exemple décrit, le dispositif de décharge active 200 comporte deux connexions 216, 218 de fourniture du signal de commande v_{GS} connectant le dispositif de commande 214 respectivement à la borne de commande G et à la borne de sortie S de l'interrupteur 212. Il sera apprécié que, puisque la thermistance 210 est connectée entre la première extrémité 206 et la borne d'entrée D, elle est située en dehors de chacune de ces connexions 216, 218 de fourniture du signal de commande v_{GS}. Ainsi, les connexions 216, 218 de fourniture du signal de commande v_{GS} évitent ou contournent la thermistance 210.

Plus précisément, le dispositif de décharge active 200 comporte une connexion 220 entre le dispositif de commande 214 et un point P de la branche 204 situé entre la borne de sortie S et la deuxième extrémité 208. Ainsi, la connexion 218 de fourniture du signal de commande v_{GS} connectant le dispositif de commande 214 à la borne de sortie S comporte la connexion 220 et la portion 222 de la branche 204 s'étendant entre le point P et la borne de sortie S.

Ainsi, le signal de commande v_{GS} est défini par le dispositif de commande 214 et est indépendant de la résistance RT de la thermistance 210.

Le signal de commande v_{GS} fourni par le dispositif de commande 214 peut être à valeur sensiblement constante (après un temps d'établissement du signal de commande v_{GS}) ou bien varier au cours de la décharge, suivant le type de commande souhaité.

Par ailleurs, le dispositif de décharge active 200 comporte un module de diagnostic 224 conçu pour vérifier le bon fonctionnement de l'interrupteur 212 (par exemple, la valeur de la tension v_{DS}) et, en cas de détection d'une défaillance de l'interrupteur 212, pour arrêter la commande CMD de décharge active afin de stopper la décharge active.

En outre, le dispositif de décharge active 200 comporte un module de vérification 226 conçu pour vérifier le bon fonctionnement de la décharge. Pour cela, le module de vérification 226 est conçu pour surveiller le courant i_{D} en mesurant la tension v_{RT} aux bornes de la thermistance 210. Il est en outre conçu pour comparer la tension mesurée à la tension attendue d'après la commande CMD. En cas, de divergence, le module 226 est conçu pour transmettre un message d'erreur au calculateur 215. Pour mesurer la tension v_{RT}, le module de vérification 226 est connecté aux bornes de la thermistance 210, par exemple aux bornes 206 et D.

Dans l'exemple illustré sur la figure 2, la capacité C1 présente une tension E égale à la somme de la tension v_{RT} aux bornes de la résistance et de la tension v_{DS} aux bornes de l'interrupteur 212. Ainsi, l'augmentation de la température de la thermistance 210 entraîne l'augmentation de la tension v_{RT}, et donc la diminution de la tension v_{DS}.

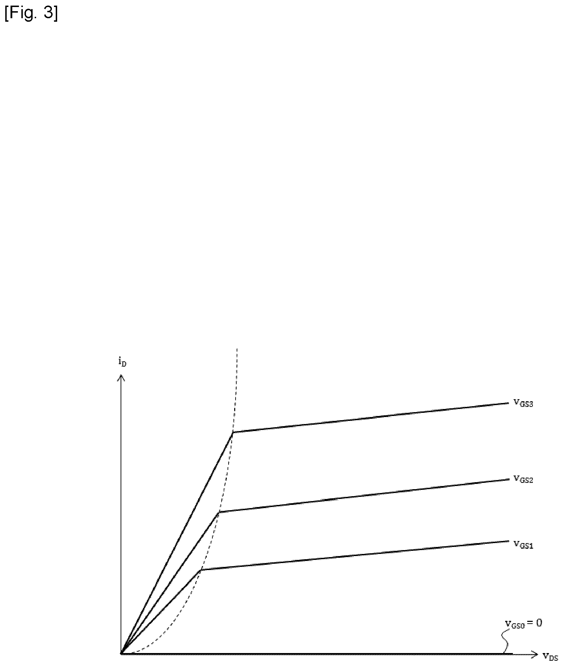

La figure 3 représente des caractéristiques courant i_{D} - tension v_{DS} de l'interrupteur 212 pour différentes valeurs croissantes de la tension v_{GS}, respectivement v_{GS0} = 0 < v_{GS1} < v_{GS2} < v_{GS3}. Comme cela est apparent, pour toutes les valeurs de V_{GS}, le courant de décharge i_{D} diminue lorsque la tension v_{DS} diminue. Il en résulte que l'augmentation de la température de la thermistance 210 entraîne la diminution du courant de décharge i_{D}, ce qui diminue l'échauffement de la thermistance 210. Ainsi, la température de la thermistance 210 est régulée, ce qui réduit le risque d'échauffement trop important de cette dernière et donc le risque d'un événement thermique dangereux (de l'anglais « Hazardous Thermal Event » ou HTE).

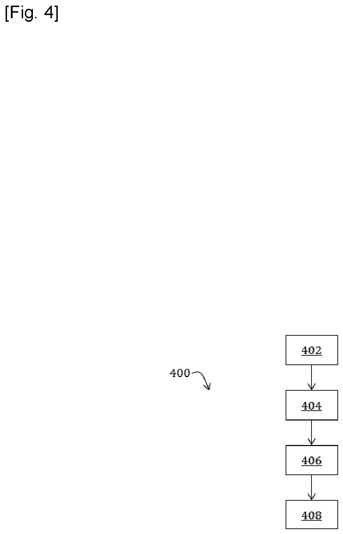

En référence à la figure 4, un procédé de décharge active 400 selon l'invention va à présent être décrit.

Au cours d'une étape 402 initiale, le dispositif de commande 214 maintient l'interrupteur 212 à l'état ouvert en ne lui fournissant aucune tension de commande v_{GS} (la tension v_{GS} est nulle). Ainsi, le courant de décharge i_{D} est nul. En outre, la thermistance 210 est à température ambiante (par exemple autour de 85°C) et présente la résistance RT associée à cette température. La tension v_{DS} est égale à la tension E de la capacité C1, qui elle-même est égale à la haute tension HT.

Au cours d'une étape 404, le dispositif de commande 214 reçoit la commande de décharge CMD et, en réponse, fournit à l'interrupteur 212 le signal de commande V_{GS}, qui dans l'exemple décrit est constant à une valeur prédéfinie, par exemple à la valeur v_{GS3}.

Au cours d'une étape 406, en réponse au signal de commande V_{GS}, l'interrupteur 212 passe à l'état fermé et draine un courant de décharge i_{D} qui entre par la première extrémité 206, traverse la thermistance 210 et l'interrupteur 212 l'un après l'autre et sort par la deuxième extrémité 208. Du fait de l'apparition du courant de décharge i_{D}, la tension v_{RT} aux bornes de la thermistance 210 prend la valeur RT × i_{D}.

Au cours d'une étape 408, le dispositif de commande 214 maintient le signal de commande V_{GS}, par exemple à valeur constante (comme la valeur V_{GS3}) ou bien suivant des variations prédéfinies prévues par le dispositif de commande 214 pendant un temps de décharge.

Pendant ce temps de décharge, la thermistance 210 remplit sa première fonction de dissipation de puissance en dissipant l'essentiel de la puissance (au moins 10 fois plus de puissance que l'interrupteur 212 comme expliqué plus haut). En même temps, la thermistance remplit sa deuxième fonction de protection thermique de la décharge en s'échauffant (par exemple jusqu'à 105°C) du fait du passage du courant de décharge i_{D} de sorte que la résistance RT augmente. Comme expliqué précédemment, cela a pour effet de diminuer la tension v_{DS} de l'interrupteur 212, et donc de diminuer le courant de décharge i_{D}, ce qui réduit l'échauffement de la thermistance 210. Ainsi, la température de la thermistance 210 est régulée.

Parallèlement, le courant de décharge i_{D} décharge la capacité C1 et provoque la diminution de la tension E, jusqu'à un seuil acceptable, par exemple moins de 60 V au bout du temps de décharge.

Il sera apprécié que, pendant le temps de décharge, grâce au fait que le dispositif de commande 214 est connecté à l'interrupteur 212 en évitant la thermistance 210, le signal de commande v_{GS} est maintenu indépendamment des variations de la résistance RT de la thermistance 214. Dit autrement, le signal de commande v_{GS} n'est pas affecté par les variations de la résistance RT.

Lorsque le dispositif de commande 214 est conçu pour maintenir le signal de commande v_{GS} constant, le signal de commande v_{GS} reste constant, indépendamment des variations de la résistance RT.

Lorsque le dispositif de commande 214 est conçu pour faire varier le signal de commande v_{GS} au cours de la décharge, ces variations se font tel que prévu par le dispositif de commande 214, indépendamment des variations de la résistance RT. En même temps que la décharge active, la thermistance remplit sa troisième fonction de vérification en permettant au module de vérification 226 de surveiller le courant i_{D} au travers de la tension v_{RT}. En cas de divergence entre la tension mesurée et la tension attendue d'après la commande CMD, le module de vérification 226 envoie un message d'erreur au calculateur 215.

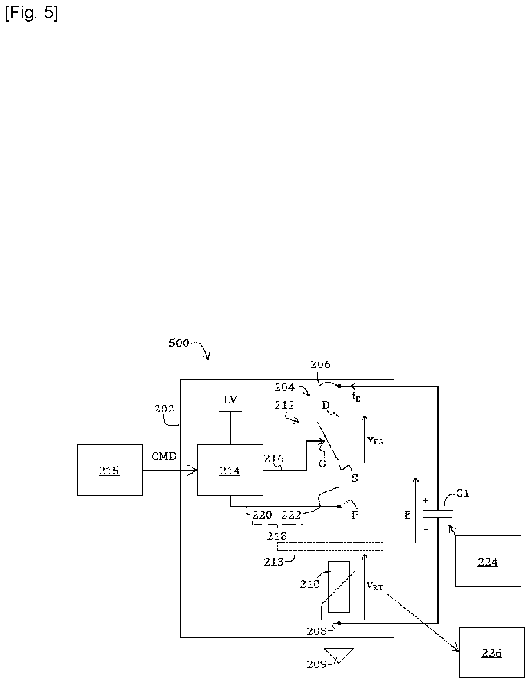

En référence à a figure 5, un dispositif de décharge active 500 du véhicule automobile 100, selon un deuxième mode de réalisation de l'invention, va à présent être décrit.

Le dispositif de décharge active 500 est identique à celui de la figure 2, si ce n'est que la thermistance 210 et l'interrupteur 212 sont inversés. Ainsi, la borne d'entrée D de l'interrupteur 212 est connectée à la première extrémité 206, tandis que la thermistance 210 est connectée, d'une part, à la borne de sortie S et, d'autre part, à la deuxième extrémité 208.

Il sera apprécié que la connexion 220 est connectée au point P de la branche 204 qui est situé entre la borne de sortie S de l'interrupteur 212 et la thermistance 210, de sorte que la connexion 218 de fourniture du signal de commande v_{GS} du dispositif de commande à la borne de sortie S évite la thermistance 210. Ainsi, le signal de commande v_{GS} est toujours indépendant de la résistance RT de la thermistance 210.

Il sera en outre apprécié que la connexion du module de vérification 226 aux bornes de la thermistance 210 est simplifiée par rapport au circuit de la figure 2 par le fait que la thermistance 210 est connectée par une de ses bornes à la masse électrique 209, de sorte que la tension v_{RT} est prise en référence à la masse électrique 209.

Le fonctionnement du dispositif de décharge active 500 est identique à celui du dispositif de décharge active 200.

Il apparaît clairement qu'un dispositif de décharge active tel que ceux décrits précédemment permet de limiter la puissance dissipée par l'interrupteur.

La présente invention n'est pas limitée aux modes de réalisation décrits précédemment, mais est au contraire définie par les revendications qui suivent. Il sera en effet apparent à l'homme du métier que des modifications peuvent y être apportées.

Par exemple, le signal de commande peut constituer en une absence de tension (ou une tension nulle) plutôt qu'e une tension non-nulle.

## Revendications

1. Dispositif de décharge active (200 ; 500) d'un dispositif de stockage d'énergie électrique (C1, C2, C3, 102, 114), comportant :
- une branche (204) comportant :
• des première et deuxième extrémités (206, 208) destinées à être respectivement connectées à des bornes positive et négative du dispositif de stockage d'énergie électrique (C1, C2, C3, 102, 114), et
• entre les deux extrémités (206, 208), une thermistance (210) présentant une résistance augmentant avec une température de la thermistance (210) et un interrupteur (212) conçu pour recevoir un signal de commande (v_{GS}) pour passer d'un état ouvert à un état fermé, la thermistance (210) et l'interrupteur (212) étant connectés l'un à l'autre de sorte que, lorsque l'interrupteur (212) est à l'état fermé, un courant de décharge (i_{D}) entre par la première extrémité (206), traverse la thermistance (210) et l'interrupteur (212) l'un après l'autre et sorte par la deuxième extrémité (208) ; et
- un dispositif de commande (214) de l'interrupteur (212) ;
le dispositif de commande (214) étant connecté à l'interrupteur (212) de manière à fournir le signal de commande (v_{GS}) indépendamment de la résistance de la thermistance (210),
**caractérisé en ce que** la thermistance (210) est conçue pour présenter une tension représentative du courant de décharge (i_{D}), mesurée par un module de vérification (226) conçu pour envoyer un message d'erreur lorsque la tension mesurée est différente d'une tension attendue d'après une commande (CMD) de l'interrupteur (212).

2. Dispositif de décharge active (200 ; 500) selon la revendication 1, comportant en outre au moins une connexion (216, 218) de fourniture du signal de commande (v_{GS}), connectant le dispositif de commande (214) à l'interrupteur (212), et dans lequel la thermistance (210) est située en dehors de chaque connexion (216, 218) de fourniture du signal de commande (v_{GS}).

3. Dispositif de décharge active (200 ; 500) selon la revendication 2, dans lequel l'interrupteur (212) présente une borne d'entrée (D) du courant de décharge (i_{D}), une borne de sortie (S) du courant de décharge (i_{D}) et une borne de commande (G), dans lequel le signal de commande (v_{GS}) est une tension de commande (v_{GS}) entre la borne de commande (G) et la borne de sortie (S), et comportant deux connexions (216, 218) de fourniture du signal de commande (v_{GS}) connectant le dispositif de commande (214) respectivement à la borne de commande (G) et à la borne de sortie (S).

4. Dispositif de décharge active (200) selon la revendication 3, dans lequel la thermistance (210) est connectée entre la première extrémité (206) de la branche (204) et la borne d'entrée (D) de l'interrupteur (212).

5. Dispositif de décharge active (500) selon la revendication 3, dans lequel la thermistance (210) est connectée entre la borne de sortie (S) de l'interrupteur (212) et la deuxième extrémité (208) de la branche (204).

6. Dispositif de décharge active (500) selon la revendication 5, dans lequel la connexion (218) de fourniture du signal de commande connectant le dispositif de commande (214) à la borne de sortie (S) comporte une connexion (220) entre le dispositif de commande (214) et un point (P) de la branche (204) situé entre la borne de sortie (S) de l'interrupteur (212) et la thermistance (210).

7. Dispositif de décharge active (200 ; 500) selon l'une quelconque des revendications 1 à 6, dans lequel la thermistance (210) est thermiquement découplée de l'interrupteur (212), par exemple au moyen d'une barrière d'isolation thermique (213) intercalée entre eux.

8. Dispositif de décharge active (200 ; 500) selon l'une quelconque des revendications 1 à 7, dans lequel la thermistance (210) est située à une distance de l'interrupteur (212) d'au moins 1 cm.

9. Dispositif de décharge active (200 ; 500) selon l'une quelconque des revendications 1 à 8, dans lequel la résistance de la thermistance (210) à 25°C est au moins 10 fois supérieure à une résistance de l'interrupteur (212) à l'état fermé, de préférence 100 fois supérieure, de préférence encore 1 000 fois supérieure.

10. Dispositif de décharge active (200 ; 500) selon l'une quelconque des revendications 1 à 9, dans lequel la thermistance (210) est conçue pour réaliser l'une ou plusieurs des fonctions suivantes, de préférence les deux :
- dissiper plus de puissance que l'interrupteur (212) ; et
- limiter le courant de décharge (i_{D}) lorsque la température de la thermistance (210) augmente.

11. Procédé (400) de décharge active d'un dispositif de stockage d'énergie électrique (C1, C2, C3, 102, 114), comportant :
- la fourniture (404) d'un signal de commande (v_{GS}) à un interrupteur (212) pour le faire passer d'un état ouvert à un état fermé, l'interrupteur (212) faisant partie d'une branche (204) comportant, en plus de l'interrupteur (212) :
• des première et deuxième extrémités (206, 208) respectivement connectées à des bornes positive et négative du dispositif de stockage d'énergie électrique (C1, C2, C3, 102, 114),
• une thermistance (210) présentant une résistance augmentant avec une température de la thermistance (210), la thermistance (210) et l'interrupteur (212) étant connectés l'un à l'autre entre les deux extrémités (206, 208), ladire thermistance (210) étant conçue pour présenter une tension représentative du courant de décharge (i_{D}), mesurée par un module de vérification (226) conçu pour envoyer un message d'erreur lorsque la tension mesurée est différente d'une tension attendue d'après une commande (CMD) de l'interrupteur (212) ;
- le passage (406) de l'interrupteur (212) à l'état fermé de sorte qu'un courant de décharge (i_{D}) entre par la première extrémité (206), traverse la thermistance (210) et l'interrupteur (212) l'un après l'autre et sorte par la deuxième extrémité (208) ;
- le maintien du signal de commande (v_{GS}) indépendamment de variations de la résistance de la thermistance (214), pendant un temps de décharge.

## Patentansprüche

1. Aktive Entladevorrichtung (200; 500) einer Speichervorrichtung für elektrische Energie (C1, C2, C3, 102, 114), die Folgendes umfasst:
- einen Zweig (204), der Folgendes umfasst:
• ein erstes und ein zweites Ende (206, 208), die dazu bestimmt sind, jeweils mit einem positiven bzw. einem negativen Anschluss der Speichervorrichtung für elektrische Energie (C1, C2, C3, 102, 114) verbunden zu sein, und
• zwischen den zwei Enden (206, 208), einen Thermistor (210), der einen mit einer Temperatur des Thermistors (210) ansteigenden Widerstandswert aufweist, und einen Schalter (212), der dazu ausgelegt ist, ein Steuersignal (v_{GS}) zu empfangen, um von einem offenen Zustand in einen geschlossenen Zustand überzugehen, wobei der Thermistor (210) und der Schalter (212) so miteinander verbunden sind, dass, wenn sich der Schalter (212) in dem geschlossenen Zustand befindet, ein Entladestrom (i_{D}) an dem ersten Ende (206) eintritt, den Thermistor (210) und den Schalter (212) nacheinander durchquert und an dem zweiten Ende (208) austritt; und
- eine Steuervorrichtung (214) des Schalters (212); wobei die Steuervorrichtung (214) so mit dem Schalter (212) verbunden ist, dass sie das Steuersignal (v_{GS}) unabhängig von dem Widerstandswert des Thermistors (210) bereitstellt,
**dadurch gekennzeichnet, dass** der Thermistor (210) dazu ausgelegt ist, eine für den Entladestrom (i_{D}) repräsentative Spannung aufzuweisen, die von einem Überprüfungsmodul (226) gemessen wird, das dazu ausgelegt ist, eine Fehlermeldung zu senden, wenn sich die gemessene Spannung von einer Spannung, die gemäß einer Ansteuerung (CMD) des Schalters (212) erwartet wird, unterscheidet.

2. Aktive Entladevorrichtung (200; 500) nach Anspruch 1, die ferner mindestens eine Verbindung (216, 218) zur Bereitstellung des Steuersignals (v_{GS}) umfasst, die die Steuervorrichtung (214) mit dem Schalter (212) verbindet, und wobei sich der Thermistor (210) außerhalb jeder Verbindung (216, 218) zur Bereitstellung des Steuersignals (v_{GS}) befindet.

3. Aktive Entladevorrichtung (200; 500) nach Anspruch 2, wobei der Schalter (212) einen Eingangsanschluss (D) für den Entladestrom (i_{D}), einen Ausgangsanschluss (S) für den Entladestrom (i_{D}) und einen Steueranschluss (G) aufweist, wobei das Steuersignal (v_{GS}) eine Steuerspannung (v_{GS}) zwischen dem Steueranschluss (G) und dem Ausgangsanschluss (S) ist, und umfassend zwei Verbindungen (216, 218) zur Bereitstellung des Steuersignals (v_{GS}), die die Steuervorrichtung (214) jeweils mit dem Steueranschluss (G) bzw. mit dem Ausgangsanschluss (S) verbinden.

4. Aktive Entladevorrichtung (200) nach Anspruch 3, wobei der Thermistor (210) zwischen dem ersten Ende (206) des Zweigs (204) und dem Eingangsanschluss (D) des Schalters (212) verbunden ist.

5. Aktive Entladevorrichtung (500) nach Anspruch 3, wobei der Thermistor (210) zwischen dem Ausgangsanschluss (S) des Schalters (212) und dem zweiten Ende (208) des Zweigs (204) verbunden ist.

6. Aktive Entladevorrichtung (500) nach Anspruch 5, wobei die Verbindung (218) zur Bereitstellung des Steuersignals, die die Steuervorrichtung (214) mit dem Ausgangsanschluss (S) verbindet, eine Verbindung (220) zwischen der Steuervorrichtung (214) und einem Punkt (P) des Zweigs (204), der sich zwischen dem Ausgangsanschluss (S) des Schalters (212) und dem Thermistor (210) befindet, umfasst.

7. Aktive Entladevorrichtung (200; 500) nach einem beliebigen der Ansprüche 1 bis 6, wobei der Thermistor (210) von dem Schalter (212) beispielsweise durch eine wärmeisolierende Barriere (213), die zwischen ihnen eingefügt ist, thermisch entkoppelt ist.

8. Aktive Entladevorrichtung (200; 500) nach einem beliebigen der Ansprüche 1 bis 7, wobei der Thermistor (210) mindestens 1 cm von dem Schalter (212) beabstandet ist.

9. Aktive Entladevorrichtung (200; 500) nach einem beliebigen der Ansprüche 1 bis 8, wobei der Widerstandswert des Thermistors (210) bei 25 °C mindestens das 10-fache, vorzugsweise das 100-fache, noch bevorzugter das 1000-fache eines Widerstandswerts des Schalters (212) im geschlossenen Zustand beträgt.

10. Aktive Entladevorrichtung (200; 500) nach einem beliebigen der Ansprüche 1 bis 9, wobei der Thermistor (210) dazu ausgelegt ist, eine oder mehrere der folgenden Funktionen, und vorzugsweise beide, auszuführen:
- mehr Leistung ableiten als der Schalter (212); und
- den Entladestrom (i_{D}) begrenzen, wenn die Temperatur des Thermistors (210) steigt.

11. Verfahren (400) zur aktiven Entladung einer Speichervorrichtung für elektrische Energie (C1, C2, C3, 102, 114), das Folgendes umfasst:
- Bereitstellen (404) eines Steuersignals (v_{GS}) für einen Schalter (212), damit dieser von einem offenen Zustand in einen geschlossenen Zustand übergeht, wobei der Schalter (212) Teil eines Zweigs (204) ist, der zusätzlich zu dem Schalter (212) Folgendes umfasst:
• ein erstes Ende und ein zweites Ende (206, 208), die jeweils mit einem positiven bzw. einem negativen Anschluss der Speichervorrichtung für elektrische Energie (C1, C2, C3, 102, 114) verbunden sind,
• einen Thermistor (210), der einen mit einer Temperatur des Thermistors (210) steigenden Widerstandswert aufweist, wobei der Thermistor (210) und der Schalter (212) zwischen den zwei Enden (206, 208) miteinander verbunden sind, wobei der Thermistor (210) dazu ausgelegt ist, eine für den Entladestrom (i_{D}) repräsentative Spannung aufzuweisen, die von einem Überprüfungsmodul (226) gemessen wird, das dazu ausgelegt ist, eine Fehlermeldung zu senden, wenn sich die gemessene Spannung von einer Spannung, die gemäß einer Ansteuerung (CMD) des Schalters (212) erwartet wird, unterscheidet;
- Übergehen (406) des Schalters (212) in den geschlossenen Zustand, sodass ein Entladestrom (i_{D}) an dem ersten Ende (206) eintritt, den Thermistor (210) und den Schalter (212) nacheinander durchquert und an dem zweiten Ende (208) austritt;
- Aufrechterhalten des Steuersignals (v_{GS}) unabhängig von Änderungen des Widerstandswerts des Thermistors (214) während eines Entladezeitraums.

## Claims

1. Device (200; 500) for actively discharging an electrical energy storage device (C1, C2, C3, 102, 114), comprising:
- a branch (204) comprising:
• first and second ends (206, 208) intended to be connected respectively to positive and negative terminals of the electrical energy storage device (C1, C2, C3, 102, 114), and
• between the two ends (206, 208), a thermistor (210) having a resistance that increases with a temperature of the thermistor (210) and a switch (212) designed to receive a control signal (v_{GS}) in order to change from an open state to a closed state, the thermistor (210) and the switch (212) being connected to one another so that, when the switch (212) is closed, a discharge current (i_{D}) enters through the first end (206), flows through the thermistor (210) and the switch (212) one after the other, and emerges through the second end (208); and
- a device (214) for controlling the switch (212); the control device (214) being connected to the switch (212) so as to provide the control signal (v_{GS}) independently of the resistance of the thermistor (210), **characterized in that** the thermistor (210) is designed to have a voltage representative of the discharge current (i_{D}), which is measured by a verification module (226) designed to send an error message when the measured voltage is different than a voltage expected according to a command (CMD) of the switch (212).

2. Active discharge device (200; 500) according to Claim 1, furthermore comprising at least one connection (216, 218) for providing the control signal (v_{GS}), which connects the control device (214) to the switch (212), and wherein the thermistor (210) is located outside each connection (216, 218) for providing the control signal (v_{GS}).

3. Active discharge device (200; 500) according to Claim 2, wherein the switch (212) has an input terminal (D) for the discharge current (i_{D}), an output terminal (S) for the discharge current (i_{D}) and a control terminal (G), wherein the control signal (v_{GS}) is a control voltage (v_{GS}) between the control terminal (G) and the output terminal (S), and comprising two connections (216, 218) for providing the control signal (v_{GS}), which connect the control device (214) respectively to the control terminal (G) and to the output terminal (S).

4. Active discharge device (200) according to Claim 3, wherein the thermistor (210) is connected between the first end (206) of the branch (204) and the input terminal (D) of the switch (212).

5. Active discharge device (500) according to Claim 3, wherein the thermistor (210) is connected between the output terminal (S) of the switch (212) and the second end (208) of the branch (204).

6. Active discharge device (500) according to Claim 5, wherein the connection (218) for providing the control signal, which connects the control device (214) to the output terminal (S), comprises a connection (220) between the control device (214) and a point (P) of the branch (204) that is located between the output terminal (S) of the switch (212) and the thermistor (210).

7. Active discharge device (200; 500) according to any one of Claims 1 to 6, wherein the thermistor (210) is thermally decoupled from the switch (212), for example by means of a thermal insulation barrier (213) interposed between them.

8. Active discharge device (200; 500) according to any one of Claims 1 to 7, wherein the thermistor (210) is located at a distance of at least 1 cm from the switch (212) .

9. Active discharge device (200; 500) according to any one of Claims 1 to 8, wherein the resistance of the thermistor (210) at 25°C is at least 10 times higher, preferably 100 times higher, more preferably 1000 times higher, than a resistance of the switch (212) in the closed state.

10. Active discharge device (200; 500) according to any one of Claims 1 to 9, wherein the thermistor (210) is designed to perform one or more, preferably both, of the following functions:
- dissipating more power than the switch (212); and
- limiting the discharge current (i_{D}) when the temperature of the thermistor (210) rises.

11. Method (400) for actively discharging an electrical energy storage device (C1, C2, C3, 102, 114), comprising:
- providing (404) a control signal (v_{GS}) to a switch (212) in order to make it change from an open state to a closed state, the switch (212) forming part of a branch (204) which, in addition to the switch (212), comprises:
• first and second ends (206, 208) respectively connected to positive and negative terminals of the electrical energy storage device (C1, C2, C3, 102, 114),
• a thermistor (210) having a resistance that increases with a temperature of the thermistor (210), the thermistor (210) and the switch (212) being connected to one another between the two ends (206, 208), said thermistor (210) being designed to have a voltage representative of the discharge current (i_{D}), which is measured by a verification module (226) designed to send an error message when the measured voltage is different than a voltage expected according to a command (CMD) of the switch (212);
- changing (406) the switch (212) to the closed state so that a discharge current (i_{D}) enters through the first end (206), flows through the thermistor (210) and the switch (212) one after the other, and emerges through the second end (208);
- maintaining the control signal (v_{GS}) independently of variations in the resistance of the thermistor (214) during a discharge time.
